(19) Europäisches Patentamt / European Patent Office / Office européen des brevets

(11) **EP 2 591 534 B1**

(12) **EUROPÄISCHE PATENTSCHRIFT**

(45) Veröffentlichungstag und Bekanntmachung des Hinweises auf die Patenterteilung:
**20.04.2016 Patentblatt 2016/16**

(21) Anmeldenummer: **11729554.3**

(22) Anmeldetag: **15.06.2011**

(51) Int Cl.:
*H02J 3/38* (2006.01)    *H02J 3/48* (2006.01)

(86) Internationale Anmeldenummer:
**PCT/EP2011/002937**

(87) Internationale Veröffentlichungsnummer:
**WO 2012/003921 (12.01.2012 Gazette 2012/02)**

(54) **VERFAHREN ZUR STEUERUNG VON PV-ANLAGEN IN EINEM STROMVERSORGUNGSNETZ**

METHOD FOR CONTROLLING PV INSTALLATIONS IN AN ELECTRICAL GRID

PROCÉDÉ DE COMMANDE D'INSTALLATIONS PHOTOVOLTAÏQUES DANS UN RÉSEAU D'ALIMENTATION EN COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.07.2010 DE 102010026299**

(43) Veröffentlichungstag der Anmeldung:
**15.05.2013 Patentblatt 2013/20**

(73) Patentinhaber: **Phoenix Contact GmbH & Co. KG
32825 Blomberg (DE)**

(72) Erfinder: **SCHÖPPNER, Helmut
88499 Riedlingen (DE)**

(74) Vertreter: **Mergel, Volker
Blumbach - Zinngrebe
Patentanwälte
Alexandrastrasse 5
65187 Wiesbaden (DE)**

(56) Entgegenhaltungen:
**DE-U1-202009 018 108**

• **ANONYMOUS: "KACO-Power-Control ermöglicht professionelles Netzeinspeisemanagement", INTERNET CITATION, 9. März 2010 (2010-03-09), Seiten 1-2, XP002573126, Gefunden im Internet: URL:http://kaco-newenergy.de/de/binary/320 /page/download.xml [gefunden am 2010-03-09]**

**Beschreibung**

Gebiet der Erfindung

Die Erfindung betrifft ein Verfahren zur Steuerung von an ein öffentliches Stromversorgungsnetz eines Energieversorgers angeschlossenen photovoltaischen Solaranlagen.

Hintergrund der Erfindung

Der Energiebedarf in einem öffentlichen Stromversorgungsnetz schwankt in Abhängigkeit der Tageszeit. Daher werden zu den Kraftwerken, welche die Grundlast decken, zu Spitzenlastzeiten zusätzliche Kraftwerke zugeschaltet.

Photovoltaische Solaranlagen liefern elektrische Energie in Abhängigkeit der Sonneneinstrahlung. Der Anteil der in das öffentliche Stromversorgungsnetz eingespeisten Solarenergie ist derzeit noch relativ gering. Die Anzahl von dezentralen photovoltaischen Solaranlagen (PV-Anlagen), z.B. private PV-Anlagen auf Hausdächern oder auch größeren kommerziellen PV-Anlagen und damit deren Anteil an der eingespeisten Leistung in das Stromversorgungsnetz nimmt aber stetig zu. Dadurch kann zu Zeiten starker Sonneneinstrahlung und gleichzeitig geringer Energieentnahme durch die Verbraucher aus dem Stromversorgungsnetz der Einspeisebedarf geringer sein, als die tatsächliche Einspeisung, wenn alle PV-Anlagen ihre momentane maximal mögliche Einspeiseleistung auch tatsächlich in das Netz einspeisen. Dies kann zu Problemen des Stromversorgungsnetzes führen.

Der Betreiber einer PV-Anlage ist ferner bestrebt, zu jedem Zeitpunkt möglichst viel Energie in das Stromversorgungsnetz einzuspeisen, d.h. seine PV-Anlage mit der bei der momentanen Sonneneinstrahlung maximal möglichen Leistung zu betreiben und diese Leistung auch einzuspeisen. Würde man bestimmte Solaranlagen zur Reduzierung der Gesamtsolareinspeiseleistung in das Stromversorgungsnetz einfach abschalten, würde dies zu einem Interessenkonflikt zwischen dem Energieversorgungsunternehmen und dem Betreiber dieser PV-Anlage führen, da dem Betreiber finanzielle Einbußen entstünden und die Wirtschaftlichkeit der Solaranlage in Frage gestellt würde.

Eine Presseinformation der KACO new energy datiert auf den 31. März 2009 beschreibt einen Funk-Rundsteuerempfänger, welcher über vier Relais-Ausgänge verfügt, die für 0, 30, 60 und 100 Prozent der Anlagen-Nennleistung stehen. Wird die Leistung abgeregelt, protokolliert das ein Datenlogger für Anlagenbetreiber.

Allgemeine Beschreibung der Erfindung

Es ist daher eine Aufgabe der vorliegenden Erfindung ein Verfahren bereit zu stellen, welches bei wachsender Einspeiseleistung von photovoltaischen Solaranlagen in den Stromversorgungsnetzen den zeitlichen Schwankungen von Einspeiseleistung und Entnahmeleistung gerecht wird und es ermöglicht, einen netzbedingten Ausfall von theoretisch möglicher Einspeiseleistung der Betreiber der Solaranlagen durch den Energieversorger präzise kompensieren zu können.

Die Aufgabe der Erfindung wird durch den Gegenstand der unabhängigen Patentansprüche gelöst. Vorteilhafte Weiterbildungen der Erfindung sind in den abhängigen Patentansprüchen definiert.

Die Aufgabe der Erfindung wird insbesondere dadurch gelöst, dass die photovoltaischen Solaranlagen prozentual heruntergefahren, aber nicht vollständig abgeschaltet werden. D.h. der Energieversorger oder das Energieversorgungsunternehmen (EVU) bestimmt in Abhängigkeit der momentanen Einspeiseleistung und der aus dem Stromversorgungsnetz momentan entnommenen Leistung einen Prozentsatz oder Bruchteilsfaktor, um welchen eine oder mehrere Solaranlagen heruntergefahren werden. Der Bruchteilsfaktor darf nicht gleich null sein, sondern ist größer als null, aber kleiner als 100%. Dadurch wird sichergestellt, dass trotz Reduktion der Einspeiseleistung jede Solaranlage eine noch messbare Energie in das Stromversorgungsnetz einspeist. Anhand dieser kontinuierlich gemessenen reduzierten eingespeisten Energie und des vom Energieversorger vorgegebenen Bruchteilsfaktors kann dann für jeden Zeitpunkt die maximal mögliche Einspeiseenergie - also wenn die Solaranlage nicht heruntergefahren worden wäre - errechnet werden, damit der Energieversorger dem Betreiber jeder Solaranlage den netzbedingten Teilausfall der Einspeisevergütung korrekt ersetzen kann.

Demnach schlägt die Erfindung ein Verfahren zur Steuerung von an ein öffentliches Stromversorgungsnetz eines Energieversorgers angeschlossenen photovoltaischen Solaranlagen vor, bei welchem eine Mehrzahl von photovoltaischen Solaranlagen elektrische Energie in das öffentliche Stromversorgungsnetz einspeisen. Es können noch weitere konventionelle Kraftwerke (fossil, nuklear etc.) im Netz vorhanden sein, insbesondere Grundlastkraftwerke, welche nicht geregelt werden sollen.

Je nach dem momentanen Verbrauch, d.h. dem momentanen Einspeisebedarf werden die Einspeiseleistungen der Solaranlagen zentral von dem Energieversorger gesteuert. Hierzu bestimmt der Energieversorger in Abhängigkeit von dem Einspeisebedarf einen von null verschiedenen Bruchteilsfaktor B ($0 < B < 100\%$) und übermittelt über eine Datenverbindung zwischen den Solaranlagen und dem Energieversorger den Bruchteilsfaktor B an die Solaranlagen, welche eine Steuerung umfassen, die dann automatisch die tatsächliche momentane Einspeiseleistung dieser Solaranlage um den vorgegebenen Bruchteilsfaktor reduzieren. Hierfür weist jede Solaranlage eine Datenübertragungseinrichtung zur Herstellung einer Datenverbindung mit dem Energieversorger auf.

Jede der Solaranlagen weist jeweils einen Solarwechselrichter und auf der Wechselstromseite des Solarwechselrichters einen geeichten Einspeise-Energiezähler auf. Der Einspeise-Energiezähler der Solaranlage misst kontinuierlich, also zeitabhängig und in kurzen Intervallen (z.B. im Sekundenbereich), die wechselstromseitige um den Bruchteilsfaktor reduzierte tatsächliche Einspeise-Energie in das Stromversorgungsnetz und übermittelt regelmäßig die jeweils gemessenen und mit Zeitstempel versehenen Energiewerte über die Datenverbindung an eine Recheneinrichtung eines zentralen Portals, wo die Daten verarbeitet und gespeichert werden. Die Übermittlung der gemessenen Energiewerte kann quasionline erfolgen oder blockweise in wesentlich größeren Zeitintervallen als die Messintervalle.

Zur Berechnung der Einspeisevergütung jedes Betreibers einer Solaranlage wird die maximal mögliche Einspeiseenergie jeder der Solaranlagen anhand des zeitlich veränderlichen Bruchteilsfaktors und der zeitlich hierzu korrelierten kontinuierlich gemessenen und übermittelten Energiewerte errechnet, so dass die Einspeisevergütung für die jeweilige Solaranlage auf Basis der so errechneten maximal möglichen Einspeiseenergie ermittelt werden kann.

Hierdurch wird sichergestellt, dass der Energieversorger einerseits die Einspeiseleistung der an das Stromversorgungsnetz angeschlossenen Solaranlagen zentral steuern kann und andererseits den Betreibern von Solaranlagen kein finanzieller Ausfall entsteht, sondern deren maximal mögliche Einspeiseleistung präzise berechnet und korrekt vergütet werden kann.

Vorzugsweise erfolgt die Reduzierung der Einspeiseleistungen der Solaranlagen jeweils mittels einer Steuerung der Leistung des Solarwechselrichters der Solaranlage. Hierzu umfasst jede Solaranlage eine interne Steuereinheit. Der Energieversorger übermittelt über eine Datenverbindung, z.B. über ein Rundsteuersignal oder eine Internet-Verbindung oder eine Mobilfunkverbindung (GSM/GPRS, UMTS) den Bruchteilsfaktor an die internen Steuereinheiten der Solaranlagen. In Ansprechen auf den Empfang des Bruchteilsfaktors steuert dann die interne Steuereinheit direkt den Solarwechselrichter, z.B. über eine analoge Normschnittstelle (0-4-20mA, 0-10V) oder über digitale Schnittstellen, z.B. RS232, RS485 oder RS422. Die dann von jeder Solaranlage noch ins Stromversorgungsnetz tatsächlich eingespeiste Energie wird mit dem geeichten Einspeise-Energiezähler der Solaranlage gemessen. Die Datenerfassung erfolgt in der internen Steuereinheit. Die eingespeiste Leistung wird kontinuierlich gemessen und mittels der Datenübertragungseinrichtung über eine Datenverbindung ggf. in einstellbaren Zeitintervallen an ein Portal des Solaranlagenherstellers, Betreibers oder ein freies Portal übertragen. Diese Daten für eine Vielzahl von Solaranlagen werden dann zentral von dem Portal an den Energieversorger übermittelt. Die Messwerte sind mit einem Zeitstempel versehen. Der Bruchteilsfaktor ist dem Energieversorger bekannt und muss nicht zwingend mit übertragen werden. Dies kann aber auf Wunsch ebenfalls geschehen. Die Berechnung der maximal möglichen Einspeiseenergie kann dann von dem Energieversorger selbst vorgenommen werden. Alternativ können die Berechnungen, wie z.B. die Berechnung der maximal möglichen Einspeiseleistung oder der Ausgleichszahlung, durch die Recheneinrichtung auf dem Portal durchgeführt und an den Energieversorger übermittelt werden. Anhand der eingespeisten Energie und des Bruchteilsfaktors, auf den der Wechselrichter zurückgefahren wurde, wird die zu vergütende Energie berechnet. Diese Daten werden in einer Aufstellung in einer Datenbank abgelegt und die Abrechnung erfolgt gemäß der Aufstellung.

Wenn die Datenverbindung zwischen einer der Solaranlagen und dem Portal unterbrochen ist, speichert diese Solaranlage automatisch die von ihrem Energiezähler kontinuierlich gemessenen Energiewerte in einem Datenspeicher dieser Solaranlage und die gespeicherten Energiewerte werden dann bei Wiederherstellung der Datenverbindung automatisch an das Portal nachübermittelt und die nachübermittelten Energiewerte werden von der zentralen Recheneinrichtung des Portals gespeichert.

Jede Solaranlage weist typischerweise einen oder mehrere Stränge jeweils mit einer Mehrzahl von Solarmodulen auf. Zusätzlich zu der Messung der eingespeisten Energie mittels des geeichten Energiezählers werden vorzugsweise auf der Gleichstromseite des Solarwechselrichters jeder Solaranlage strangweise Strommessungen durchgeführt. Die jeweils gemessenen strangweisen Gleichstromwerte werden ebenfalls von jeder Solaranlage regelmäßig über die Datenverbindung an die zentrale Recheneinrichtung des Portals übermittelt und dort gespeichert. Auch die gemessenen strangweisen Gleichstromwerte werden bei einer Unterbrechung der Datenverbindung automatisch von der Solaranlage gespeichert und dann bei Wiederherstellung der Datenverbindung automatisch an den Energieversorger nachübermittelt. Die nachübermittelten Gleichstromwerte werden ebenfalls von der zentralen Recheneinrichtung des Portals gespeichert.

Mittels der strangweisen Gleichstrommesswerte kann zusätzlich zur Wechselstromseite noch die Energie auf der Gleichstromseite erfasst werden. Damit kann die Leistung auf der Gleichstromseite ermittelt werden und ggf. z.B. ein schlechter Wirkungsgrad in die Berechnung eingehen. Vorzugsweise werden wie vorstehend beschrieben ist, alle Messdaten an das Portal übermittelt. Die Gleichstromwerte werden ebenfalls an das Portal übermittelt und können von dort dem Energieversorger übermittelt werden.

Gemäß einer einfachen Ausführungsform der Erfindung umfassen die Solaranlagen jeweils einen Rundsteuerempfänger und die bruchteilsmäßige Reduzierung der Einspeiseleistungen der Solaranlagen wird über ein von dem Rundsteuerempfänger empfangenes Rundsteuersignal getriggert. Derzeit erfolgt auf diesem Weg die Umschaltung der Energiezähler für niedrigere Tarife. Daher kann in vorteilhafter Weise diese bereits vorhandene Infrastruktur der Rundsteuersignale zum Triggern der bruchteilsmäßigen Reduzierung der Einspeiseleistungen der Solaranlagen genutzt werden.

Ferner werden bevorzugt die jeweils mit einem Zeitstempel versehenen Bruchteilsfaktoren der Solaranlagen regelmäßig über die Datenverbindung zwischen den Solaranlagen und dem Portal an das Portal übermittelt und dort zentral gespeichert. Hierdurch wird sichergestellt, dass die um den Bruchteilsfaktor korrigierte Einspeisevergütung nur dann zum Tragen kommt, wenn die Reduzierung der Einspeise-Energie gemäß dem Bruchteilsfaktor von der konkreten Solaranlage auch tatsächlich umgesetzt wurde.

Übergreifend betrachtet, ermöglicht die Erfindung somit ein Stromversogungsnetz zur Versorgung einer Vielzahl von Abnehmern mit elektrischer Energie, i) mit einer Vielzahl von in das Stromversorgungsnetz einspeisenden Kraftwerken, ii) einer Vielzahl von in das Stromversorgungsnetz einspeisenden photovoltaischen Solaranlagen und iii) einer Vielzahl von Abnehmern, welche von dem Stromversorgungsnetz mit elektrischer Energie versorgt werden, wobei jede der entsprechend ausgerüsteten Solaranlagen i) zumindest einen in der Leistung steuerbaren Solarwechselrichter zum Umrichten der von der Solarmodulen erzeugten Gleichspannung in netzkonforme Wechselspannung, ii) eine Datenübertragungseinrichtung zur Herstellung einer Datenverbindung mit dem Energieversorger und iii) einen geeichten Einspeise-Energiezähler auf der Wechselstromseite des Solarwechselrichters umfasst. Der geeichte Einspeise-Energiezähler ist hierbei zur zyklischen Messung der in das öffentliche Stromversorgungsnetz tatsächlich eingespeisten Energie und zur zyklischen Übermittlung der jeweils gemessenen Energiewerte hergerichtet. Mit anderen Worten integriert der Einspeise-Energiezähler nicht lediglich die eingespeiste Energie über einen langen Zeitraum, sondern misst die eingespeiste Energie kontinuierlich in zyklischen Zeitintervallen und gibt die zeitaufgelösten Messwerte aus. Diese Energiewerte (Messdaten) sowie der jeweils zugehörige (zeitlich hierzu korrelierte) von null verschiedene Bruchteilsfaktor der maximal möglichen Einspeiseleistung auf die Solaranlage heruntergeregelt wurde, werden von jeder Solaranlage über die Datenverbindung an die zentrale Recheneinrichtung des Portals übermittelt. Die Recheneinrichtung des Portals kann dann anhand des Bruchteilsfaktors und dem zeitlich hierzu korrelierten kontinuierlich gemessenen und an die Recheneinrichtung des Portals übermittelten Energiewert der jeweiligen Solaranlage errechnen, wie hoch zu jeden Zeitpunkt die maximal (theoretisch) mögliche Einspeise-Energie gewesen wäre, wenn die Solaranlage nicht um den Bruchteilsfaktor heruntergeregelt worden wäre und kann die korrekte Einspeisevergütung für die jeweilige Solaranlage auf Basis der so errechneten maximal (theoretisch) möglichen Einspeiseenergie ermitteln.

Die Berechnung kann also auf dem Portal erfolgen und die errechnete maximal mögliche Einspeiseenergie jeder Solaranlage wird dann von dem Portal an den Energieversorger übermittelt. Es ist aber auch möglich, dass der Energieversorger das Portal zur Verfügung stellt und die Berechnung selbst durchführt.

Im Folgenden wird die Erfindung anhand eines Ausführungsbeispiels und unter Bezugnahme auf die Figur näher erläutert.

Kurzbeschreibung der Figur

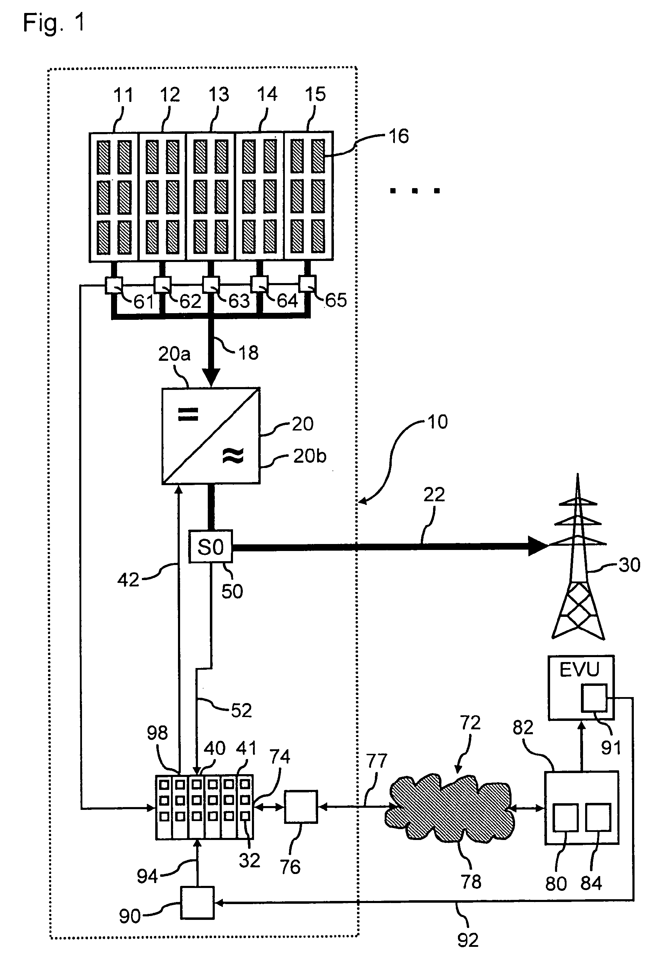

Fig. 1 zeigt ein schematisches Blockschaltbild einer beispielhaften Ausführungsform der vorliegenden Erfindung.

Detaillierte Beschreibung der Erfindung

Fig. 1 zeigt eine photovoltaische Solaranlage 10 mit fünf Strängen 11, 12, 13, 14, 15, wobei jeder Strang eine Mehrzahl von Solarmodulen 16 enthält. Die fünf Stränge sind parallel geschaltet und deren Gleichstromleistung wird über die Gleichstromleitung 18, in den Wechselrichter 20 eingespeist und von dem Wechselrichter 20 in netzkonforme Wechselspannung umgerichtet. Selbstverständlich kann die Solaranlage auch eine andere Anzahl von Strängen aufweisen. Die Wechselspannung wird dann über die Leitung 22 in das öffentliche Stromversorgungsnetz 30 eingespeist. An den Wechselrichter 20 ist der Datenlogger 41 der Solaranlage 10 angeschlossen, welcher den Wechselrichter 20 steuert. Die Steuerleitung mit welcher der Datenlogger 41 mit dem Wechselrichter verbunden ist, ist mit 42 bezeichnet. Der ohnehin in der PV-Anlage vorhandene Datenlogger 41 umfasst demnach die interne Steuereinheit 40 der Solaranlage zur Steuerung der Einspeiseleistung.

Zwischen dem Wechselrichter 20 und dem Einspeisepunkt in das Stromversorgungsnetz 30, also auf der Wechselstromseite 20b des Wechselrichters 20 ist ein Einspeise-Energiezähler 50 vorgesehen, welcher die von der Solaranlage in das Stromversorgungsnetz eingespeiste Energie misst. Vorzugsweise wird hierfür ein geeichter S0-Zähler 50 verwendet, welcher über die Datenleitung 52 die Messwerte der Einspeise-Energie an die zur Solaranlage 10 gehörige Steuereinheit 40 übermittelt. Es sind eine Vielzahl von Solaranlagen 10 (von denen in der Fig.1 der Einfachheit halber nur eine dargestellt ist) an das Stromversorgungsnetz 30 angeschlossen.

Zwischen den Solarmodulen und dem Wechselrichter 20, also gleichstromseitig 20a, sind strangweise Gleichstrommessgeräte 61, 62, 63, 64, 65 vorgesehen. Hiermit kann für jeden Strang 11, 12, 13, 14, 15 einzeln der dem Wechselrichter 20 zugeführte Gleichstrom gemessen werden.

Sowohl die von dem Einspeise-Energiezähler 50 gemessenen Energiewerte der Solaranlage 10 als auch die strangweisen Stromwerte der Gleichstrommessgeräte 61, 62, 63, 64, 65 werden von der Solaranlagen-internen Steuereinheit 40 erfasst. Diese Messwerte werden jeweils mit einem Zeitstempel versehen und über die Datenverbindung 72 an eine zentrale Recheneinrichtung 80 des Portals 82 übermittelt und dort gespeichert und ausgewertet.

Die Kommunikation der Solaranlage 10 mit dem Portal 82 bzw. der Recheneinrichtung 80 erfolgt z.B. über eine Ethernetschnittstelle 74, welche über einen DSL-Router 76 ins Internet 78 eingebunden wird. Die Kommunikation mit der Recheneinrichtung 80 erfolgt dabei über die entsprechenden Adressen. Alternativ kann eine GSM/GPRS oder UMTS-Schnittstelle verwendet werden, was den Vorteil hat, dass die Kabelverbindung 77 für den Datentransfer von der Solaranlage in das Datennetzwerk 78 entfallen kann. Hierfür kann direkt eine SIM-Karte in die interne Steuereinheit 40 eingebaut werden.

Wenn die Datenverbindung zwischen der internen Steuereinheit 40 und der Recheneinrichtung 80 des Portals 82 unterbrochen sein sollte, werden die Messwerte im Datenspeicher 32 der internen Steuereinheit 40 zwischengespeichert und bei erneutem Verbindungsaufbau an die Recheneinrichtung 80 übermittelt. Die Messintervalle und/oder die Intervalle in denen die Daten an das Portal 82 übertragen werden, sind einstellbar.

Darüber hinaus können aus den Messwerten Veränderungen an der Solaranlage erkannt werden. Dies können Verschmutzungen, Fehlstellen, Ausfälle oder ein schlechter Wirkungsgrad sein. Derartige Fehlermeldungen werden von dem Datenlogger 41 an die Recheneinrichtung 80 gesendet. Von der Recheneinrichtung 80 können aber auch aus den gesendeten Messwerten weitere Fehler abgeleitet werden.

Der Datenlogger 41 kann ferner um weitere Zusatzfunktion erweitert werden. Z.B. können Einbruchssensoren, Windmessgeräte, Messgeräte für die Sonneneinstrahlung sowie Messgeräte für weitere physikalische Größen (nicht dargestellt), welche für den Betrieb der Solaranlage 10 relevant sind, angeschlossen werden. Der Datenlogger 41 kann außerdem in eine vorhandene Diebstahlschutzanlage (nicht dargestellt) integriert werden oder der Datenlogger 41 kann die Funktion der Diebstahlschutzanlage vollständig übernehmen. Diese Daten können z.B. Informationen geben, warum geringe Werte vorliegen, obwohl die Solaranlage nicht heruntergefahren wurde.

Ferner können von der Recheneinrichtung 80 weitere Aktivitäten des Datenloggers 41, wie z.B. das Abrufen eines Software-Updates ausgelöst werden. Ferner können Direktmessungen von der Recheneinrichtung 80 angefordert werden. Z.B. kann vom Portal 82 ein Update für Anpassungen der Schnittstelle zum Wechselrichter 20 oder einer Erweiterung des Funktionsumfangs der Solaranlage 10 heruntergeladen werden. Ferner kann ein Firmware Update für den Controller aus der Ferne geladen werden, um auf Änderungen im GSM-, GPRS- oder UMTS-Netz zu reagieren. Beide Möglichkeiten erlauben ein ständiges Anpassen an aktuelle Gegebenheiten.

Die interne Steuereinheit 40 ist über die Datenverbindung 92 von dem Energieversorger steuerbar. Insbesondere kann der Energieversorger EVU einen festgelegten von null verschiedenen Bruchteilsfaktor B (0 < B < 100%), z.B. 25% an die interne Steuereinheit 40 übermitteln. In Ansprechen hierauf steuert die interne Steuereinheit 40 dann die Leistung des Wechselrichters 20 auf den Bruchteil B herunter, in diesem Beispiel 25%.

Die korrekte Vergütung kann durch eine Ausgleichszahlung zusätzlich zur Vergütung für die tatsächlich noch eingespeiste Energie erfolgen. Die Ausgleichszahlung des Energieversorgers wird wie folgt ermittelt:

$$A = E \cdot V \cdot \left(\frac{1}{B} - 1\right)$$

mit

A: Ausgleichszahlung des Energieversorgers
E: Eingespeiste Energie
V: Vergütungssatz für Solarenergie
B: Bruchteilsfaktor

Z.B. E = 2,5kWh, V = 0,39 Euro/kWh, B = 25% ergibt

$$A = 2,5kWh \cdot 0,39\,Euro / kWh \cdot \left(\frac{1}{0,25} - 1\right) = 2,925\,Euro$$

Die zu vergütende maximal mögliche Einspeise-Energie ergibt sich aus der Summe der Ausgleichszahlung A und der Einspeisevergütung der tatsächlich eingespeisten Energie *(E.V).*

In diesem Beispiel ist ein Rundsteuerempfänger 90 an die interne Steuereinheit 40 angeschlossen und die Solaranlage 10 wird über ein Rundsteuersignal getriggert, welches der Rundsteuerempfänger 90 über eine Datenverbindung 92 erhält. Hierfür wird der von dem Energieversorger EVU vorgegebene Bruchteilsfaktor von einem Rundsteuersender 91 auf das Rundsteuersignal aufmoduliert, über die vorhandene Netzleitung an den Rundsteuerempfänger 92 übermittelt und vom Rundsteuerempfänger 92 demoduliert. In vorteilhafter Weise ist somit keine separate Datenleitung für die Übermittlung des Bruchteilsfaktors und die Triggerung der Leistungsreduktion erforderlich, da die Übermittlung über eine auf die Netzleitung geschaltete Datenverbindung erfolgt. Die Steuerung könnte aber auch indirekt, z.B. über das Portal erfolgen. Der Bruchteilsfaktor wird anschließend von dem Rundsteuerempfänger 90 über eine Verbindungsleitung zur internen Steuereinheit 40 im Datenlogger 41 übertragen.

Der Pfeil mit dem Bezugszeichen 94 zeigt die Wirkrichtung des Steuersignals auf die interne Steuereinheit 40 und der Pfeil mit dem Bezugszeichen 42 von der internen Steuereinheit 40 auf den Wechselrichter 20. Wenn die Rundsteuereinrichtung 90 ein Rundsteuersignal empfängt, wird dieses von der integrierten Steuerung ausgewertet. Die Solaranlagen-interne Steuereinheit 40 steuert dann über die Steuerleitung 42 die Leistung des Wechselrichters 20 auf den Bruchteil B, z.B. 25% herunter. Diese Steuerung erfolgt in dem Beispiel über ein Analogsignal 4-20mA. Es können aber auch andere Schnittstellen 98, wie z.B. eine serielle Schnittstelle RS232, RS484, RS422, Interbus, Profibus, modbus etc. in der internen Steuereinheit 40 integriert sein und hierfür verwendet werden.

Der Wechselrichter 20 reduziert die in das Stromversorgungsnetz 30 eingespeiste Energie dann auf den vorgegebenen Bruchteilsfaktor B, z.B. 25%. Die strangweise gemessenen Stromwerte sowie die vom S0-Zähler 50 gemessenen eingespeisten Energiewerte werden weiterhin zyklisch über die Datenverbindung 72 an die Recheneinrichtung 80 des Portals 82 übertragen. Diese Werte werden in einer Datenbank in einem Datenspeicher 84 des Portals 82 mit einem Zeitstempel versehen abgespeichert. Der Bruchteilsfaktor B auf den der Wechselrichter 20 heruntergefahren wurde, wird zusammen mit diesen Daten abgespeichert, so dass aus diesen Daten ein zeitaufgelöstes Energieprofil für diese Solaranlage 10 (und für jede weitere gleichermaßen eingerichtete Solaranlage) erstellt werden kann, also die tatsächlich eingespeiste Energie als Funktion der Zeit. Mittels zeitlicher Korrelation mit dem Bruchteilsfaktor B wird die maximal mögliche Einspeiseenergie der Solaranlage 10 als Funktion der Zeit berechnet. Diese Funktion wird dann über den Vergütungszeitraum aufintegriert um die Einspeisevergütung bzw. die Ausgleichszahlung zu ermitteln.

Für die vorliegende Erfindung ist es vorteilhaft, die tatsächliche Einspeiseenergie oder -leistung an der Solaranlage 10 mit einem geeichten Energiezähler 50 zu messen. Die Messwerte werden über ein Sicherungskonzept auf der Serverseite entsprechend gesichert und einsehbar gemacht, um Manipulationen zu verhindern. Für die Abrechnung mit dem Energieversorger wird der Fachmann ein geeignetes Protokoll verwenden, welches mit dem Energieversorger abgestimmt wird.

Es ist dem Fachmann ersichtlich, dass die vorstehend beschriebenen Ausführungsformen beispielhaft zu verstehen sind, und die Erfindung nicht auf diese beschränkt ist, sondern in vielfältiger Weise variiert werden kann, ohne die Erfindung zu verlassen. Ferner ist ersichtlich, dass die Merkmale unabhängig davon, ob sie in der Beschreibung, den Ansprüchen, den Figuren oder anderweitig offenbart sind auch einzeln wesentliche Bestandteile der Erfindung definieren, selbst wenn sie zusammen mit anderen Merkmalen gemeinsam beschrieben sind.

**Patentansprüche**

1. Verfahren zur Steuerung von an ein öffentliches Stromversorgungsnetz (30) eines Energieversorgers angeschlossenen photovoltaischen Solaranlagen (10), bei welchem
eine Mehrzahl von photovoltaischen Solaranlagen (10) elektrische Energie in das öffentliche Stromversorgungsnetz (30) einspeisen,
je nach Einspeisebedarf die Einspeiseleistungen der Solaranlagen (10) von dem Energieversorger gesteuert werden, wobei der Energieversorger an die Solaranlagen (10) einen von null verschiedenen Bruchteilsfaktor (B) übermittelt, die Solaranlagen (10) jeweils einen Solarwechselrichter (20) und auf der Wechselstromseite (20b) des Solarwechselrichters (20) einen Einspeise-Energiezähler (50) umfassen, wobei der wechselstromseitige Einspeise-Energiezähler (50) kontinuierlich die in das öffentliche Stromversorgungsnetz (30) tatsächlich eingespeiste Energie misst und die jeweils gemessenen Energiewerte über eine Datenverbindung (72) zwischen den Solaranlagen (10) und einem Portal (82) regelmäßig an eine Recheneinrichtung (80) des Portals (82) übermittelt und dort gespeichert werden;
**dadurch gekennzeichnet, dass**
die tatsächliche momentane Einspeiseleistungen der Solaranlagen um den Bruchteilsfaktor (B) reduziert werden und die maximal mögliche Einspeiseenergie der Solaranlagen (10) anhand des Bruchteilsfaktors (B) und der zeitlich hierzu korrelierten kontinuierlich gemessenen Energiewerte errechnet wird und die Einspeisevergütung für die jeweilige Solaranlage (10) auf Basis der so errechneten maximal möglichen Einspeiseenergie ermittelt wird.

**2.** Verfahren nach Anspruch 1,
wobei die Reduzierung der Einspeiseleistungen der Solaranlagen (10) jeweils mittels einer Steuerung des Solarwechselrichters (20) der Solaranlage (10) erfolgt.

**3.** Verfahren nach Anspruch 2,
wobei jede Solaranlage einen Datenlogger (41) umfasst und die Solarwechselrichter (20) von dem Datenlogger der jeweiligen Solaranlage gesteuert werden, um die Reduzierung der Einspeiseleistung zu bewirken.

**4.** Verfahren nach einem der vorstehenden Ansprüche,
wobei bei einer Unterbrechung der Datenverbindung (72) zwischen einer der Solaranlagen (10) und dem Portal (82) diese Solaranlage (10) automatisch die gemessenen Energiewerte in einem Datenspeicher (32) dieser Solaranlage (10) speichert und die gespeicherten Energiewerte bei Wiederherstellung der Datenverbindung (72) automatisch an das Portal (82) nachübermittelt und die nachübermittelten Energiewerte von dem Portal (82) gespeichert werden.

**5.** Verfahren nach einem der vorstehenden Ansprüche,
wobei auf der Gleichstromseite (20a) des Solarwechselrichters (20) jeder Solaranlage (10) strangweise Strommessungen (61-65) durchgeführt werden und über die Datenverbindung (72) zwischen den Solaranlagen (10) und dem Portal (82) die jeweils gemessenen strangweisen Gleichstromwerte regelmäßig von den Solaranlagen (10) an die zentrale Recheneinrichtung (80) des Portals (82) übermittelt und dort gespeichert werden.

**6.** Verfahren nach Anspruch 5,
wobei bei einer Unterbrechung der Datenverbindung (72) zwischen einer der Solaranlagen (10) und dem Portal (82) diese Solaranlage (10) automatisch die gemessenen Gleichstromwerte in dem Datenspeicher (32) dieser Solaranlage (10) speichert und die gespeicherten Gleichstromwerte bei Wiederherstellung der Datenverbindung automatisch an das Portal (82) nachübermittelt und die nachübermittelten Gleichstromwerte von dem Portal (82) gespeichert werden.

**7.** Verfahren nach einem der vorstehenden Ansprüche,
wobei die Solaranlagen (10) jeweils einen Rundsteuerempfänger (90) umfassen und die bruchteilsmäßige Reduzierung der Einspeiseleistungen der Solaranlagen (10) über ein von dem Rundsteuerempfänger (90) empfangenes Rundsteuersignal (92) getriggert wird.

**8.** Verfahren nach einem der vorstehenden Ansprüche,
wobei die jeweils mit einem Zeitstempel versehenen Bruchteilsfaktoren (B) der Solaranlagen (10) über die Datenverbindung (72) zwischen den Solaranlagen (10) und dem Portal (82) an das Portal (82) übermittelt werden und dort zentral gespeichert werden.

**9.** System mit einem Energieversorger, einem Stromversorgungsnetz (30) zur Versorgung einer Vielzahl von Abnehmern mit elektrischer Energie, einer Vielzahl von in das Stromversorgungsnetz (30) einspeisenden Kraftwerken, einer Vielzahl von in das Stromversorgungsnetz (30) einspeisenden photovoltaischen Solaranlagen (10), einer Vielzahl von Abnehmern, welche von dem Stromversorgungsnetz (30) mit elektrischer Energie versorgt werden und einem zentralen Portal (82),
wobei die photovoltaischen Solaranlagen (10) jeweils umfassen:

- zumindest einen Solarwechselrichter (20) zum Umrichten der von den Solarmodulen (16) erzeugten Gleichspannung (18) in netzkonforme Wechselspannung (22),
- eine Datenübertragungseinrichtung (74, 76, 77) zum Herstellen einer Datenverbindung (72) mit dem Portal (82),
- einen Einspeise-Energiezähler (50) auf der Wechselstromseite (20b) des Solarwechselrichters (20), ausgebildet zur kontinuierlichen Messung der in das öffentliche Stromversorgungsnetz (30) tatsächlich eingespeisten Energie und zur regelmäßigen Übermittlung der jeweils gemessenen Energiewerte über die Datenverbindung (72) an eine zentrale Recheneinrichtung (80) des Portals (82),
- eine interne Steuereinheit (40) zum Steuern der Leistung der jeweiligen Solaranlage (10),

wobei der Energieversorger mittels der Datenverbindung (92) mit den Solaranlagen (10) verbunden ist und so ausgebildet ist, dass er je nach Einspeisebedarf einen von null verschiedenen Bruchteilsfaktor (B) an die internen Steuereinheiten (40) der Solaranlagen übermittelt,
**dadurch gekennzeichnet, dass**

die internen Steuereinheiten (40) dazu ausgebildet sind, die Einspeiseleistung der jeweiligen Solaranlage (10) auf den von null verschiedenen Bruchteilsfaktor (B) zu reduzieren und

dass der Energieversorger oder das Portal so ausgebildet sind, dass

die maximal mögliche Einspeise-Energie jeder der Solaranlagen (10) anhand des Bruchteilsfaktors (B) und des zeitlich hierzu korrelierten kontinuierlich gemessenen und an die Recheneinrichtung (80) des Portals (82) übermittelten Energiewerts der jeweiligen Solaranlage (10) errechnet wird, und die Einspeisevergütung für die jeweilige Solaranlage (10) auf Basis der so errechneten maximal möglichen Einspeiseenergie ermittelt wird.

10. Photovoltaische Solaranlage (10) zum Anschluss an ein öffentliches Stromversorgungsnetz (30) eines Energieversorgers, umfassend:

einen oder mehrere Stränge (11-15) mit einer Mehrzahl von Solarmodulen (16),

zumindest einen in der Leistung steuerbaren Solarwechselrichter (20) zum Umrichten der von den Solarmodulen (10) erzeugten Gleichspannung (18) in netzkonforme Wechselspannung (22),

eine Datenübertragungseinrichtung (74, 76, 77) zum Herstellen einer Datenverbindung (72) mit einem Portal (82),

einen Einspeise-Energiezähler (50) auf der Wechselstromseite (20b) des Solarwechselrichters (20), ausgebildet zur kontinuierlichen Messung der in das öffentliche Stromversorgungsnetz (30) tatsächlich eingespeisten Energie und zur regelmäßigen Übermittlung der jeweils gemessenen Energiewerte über die Datenverbindung (72) an eine zentrale Recheneinrichtung (80) des Portals (82),

eine interne Steuereinheit (40), ausgebildet zum Steuern der Leistung des Solarwechselrichters (20) auf einen von dem Energieversorger empfangenen von null verschiedenen Bruchteilsfaktor (B),

**dadurch gekennzeichnet, dass**

die interne Steuereinheit (40) so ausgebildet ist, dass sie die tatsächliche momentane Einspeiseleistung der Solaranlage um den vorgegebenen Bruchteilsfaktor (B) reduziert, so dass die maximal mögliche Einspeiseenergie der Solaranlage anhand des zeitlich veränderlichen Bruchteilsfaktors und der zeitlich hierzu korrelierten kontinuierlich gemessenen und übermittelten Energiewerte errechnet werden kann.

## Claims

1. A method for controlling photovoltaic solar systems (10) connected to a public electric grid (30) of an energy provider, wherein

a plurality of photovoltaic solar systems (10) feed electric energy into the public electric grid (30),

the feed-in power of the photovoltaic systems (10) is controlled by the energy provider depending on feed-in requirements, wherein the energy provider transmits a non-zero fraction factor (B) to the photovoltaic systems (10), the photovoltaic systems (10) each comprise a photovoltaic inverter (20) and a feed-in electricity meter (50) on the AC side (20b) of said photovoltaic inverter (20), wherein said AC side feed-in electricity meter (50) continuously measures the power actually fed into the public electric grid (30), and the respective measured power data are periodically transmitted over a data connection (72) between the photovoltaic systems (10) and a portal (82) to a computing device (80) of the portal (82) to be stored therein, **characterized in that**

the actual current feed-in powers of the photovoltaic systems (10) are reduced by the fraction factor (B) and the maximum possible feed-in power of the photovoltaic systems (10) is calculated using the fraction factor (B) and the continuously measured power data time-correlated therewith, and the feed-in remuneration for the respective photovoltaic system (10) is determined based on the thus calculated maximum possible feed-in power.

2. The method as claimed in claim 1, wherein the reduction of the feed-in power of each of the photovoltaic systems (10) is effected by controlling the photovoltaic inverter (20) of the photovoltaic system (10).

3. The method as claimed in claim 2, wherein each photovoltaic system comprises a data logger (41), and the photovoltaic inverters (20) are controlled by the data logger of the respective photovoltaic system to effect the reduction of feed-in power.

4. The method as claimed in any of the preceding claims, wherein upon an interruption of the data connection (72) between one of the photovoltaic systems (10) and the portal (82), this photovoltaic system (10) automatically stores the measured power data in a data memory (32) of this photovoltaic system (10) and upon restoration of the data connection (72) subsequently automatically transfers the stored power data to the portal (82), and the subsequently transferred power data are stored by the portal (82).

**5.** The method as claimed in any of the preceding claims, wherein current measurements (61 - 65) are performed for each string on the DC side (20a) of the photovoltaic inverter (20) of each photovoltaic system (10), and the respective measured direct current data are periodically transmitted over the data connection (72) between the photovoltaic systems (10) and the portal (82) from the photovoltaic systems (10) to the central computing device (80) of the portal (82) to be stored therein.

**6.** The method as claimed in claim 5, wherein upon an interruption of the data connection (72) between one of the photovoltaic systems (10) and the portal (82), this photovoltaic system (10) automatically stores the measured direct current data in the data memory (32) of this photovoltaic system (10) and upon restoration of the data connection (72) subsequently automatically transfers the stored direct current data to the portal (82), and the subsequently transferred direct current data are stored by the portal (82).

**7.** The method as claimed in any of the preceding claims, wherein each of the photovoltaic systems (10) comprises a ripple control receiver (90), and wherein the fractional reduction of feed-in power of the photovoltaic systems (10) is triggered by a ripple control signal (92) received by said ripple control receiver (90).

**8.** The method as claimed in any of the preceding claims, wherein the fraction factors (B) of the photovoltaic systems (10) are each time-stamped and transmitted over the data connection (72) between the photovoltaic systems (10) and the portal (82) to the portal (82) and centrally stored therein.

**9.** System with an energy provider, an electric grid (30) for supplying a plurality of consumers with electric energy, a plurality of power plants feeding into the electric grid (30), a plurality of photovoltaic solar systems (10) feeding into the electric grid (30), a plurality of consumers which are supplied with electric energy from the electric grid (30), and a central portal (82),
wherein each of the photovoltaic solar systems (10) comprises:

- at least one photovoltaic inverter (20) for converting the DC voltage (18) generated by the photovoltaic modules (16) into grid-compatible alternating voltage (22);
- a data transmission device (74, 76, 77) for establishing a data connection (72) with the portal (82);
- a feed-in electricity meter (50) on the AC side (20b) of the photovoltaic inverter (20), adapted for continuously measuring the power actually fed into the public electric grid (30) and for periodically transmitting the respective measured power data over the data connection (72) to a central processing device (80) of the portal (82);
- an internal control unit (40) for controlling the power of the respective photovoltaic system (10);

wherein the energy provider is connected to the photovoltaic systems (10) by a data connection (92) and transmits a feed-in requirement depending non-zero fraction factor (B) to the internal control units (40) of the photovoltaic systems, **characterized in that**
the internal control units (40) reduce the feed-in power of the respective photovoltaic system (10) to the non-zero fraction factor (B); and that the energy provider or the portal are designed such, that the maximum possible feed-in power of each of the photovoltaic systems (10) is calculated using the fraction factor (B) and the continuously measured power data time-correlated therewith and transmitted to the computing device (80) of the portal (82), and wherein the feed-in remuneration for the respective photovoltaic system (10) is determined based on the thus calculated maximum possible feed-in power.

**10.** A photovoltaic solar system (10) for connection to a public electric grid (30) of an energy provider, comprising:

one or more strings (11 - 15) each comprising a plurality of solar modules (16);
at least one power-controllable photovoltaic inverter (20) for converting the DC voltage (18) generated by the solar modules (16) into grid-compatible AC voltage;
a data transmission device (74, 76, 77) for establishing a data connection (72) with a portal (82);
a feed-in electricity meter (50) on the AC side (20b) of the photovoltaic inverter (20) adapted for continuously measuring the power actually fed into the public electric grid (30) and for periodically transmitting the respective measured power data over the data connection (72) to a central processing device (80) of the portal (82),
an internal control unit (40) adapted for reducing the actual current feed-in power of the photovoltaic system by the fraction factor (B) so that the maximum possible feed-in power of the photovoltaic system can be calculated by the time-variable fraction factor and the periodically measured and transmitted energy values, which are correlated in time with the fraction factor.

**Revendications**

1. Procédé de commande d'installations solaires photovoltaïques (10) raccordées à un réseau public d'alimentation en courant (30) d'un fournisseur d'énergie, selon lequel

une pluralité d'installations solaires photovoltaïques (10) injectent de l'énergie électrique dans le réseau public d'alimentation en courant (30),

suivant les besoins d'alimentation, les puissances d'alimentation des installations solaires (10) sont commandées par le fournisseur d'énergie, sachant que le fournisseur d'énergie transmet un facteur fractionnaire (B) différent de zéro aux installations solaires (10),

les installations solaires (10) comportent chacune un onduleur solaire (20) et, côté courant alternatif (20b) de l'onduleur solaire (20), un compteur d'énergie d'alimentation (50), le compteur d'énergie d'alimentation (50) côté courant alternatif mesurant en continu l'énergie effectivement injectée dans le réseau public d'alimentation en courant (30), et les valeurs d'énergie respectivement mesurées étant transmises régulièrement à un dispositif de calcul (80) d'un portail (82), par l'intermédiaire d'une connexion de données (72) entre les installations solaires (10) et le portail (82), et étant stockées dans celui-ci,

**caractérisé en ce que**

les puissances d'alimentation momentanées effectives des installations solaires sont réduites du facteur fractionnaire (B), et

l'énergie d'alimentation maximale possible des installations solaires (10) est calculée à l'aide du facteur fractionnaire (B) et des valeurs d'énergie mesurées en continu et mises en corrélation temporelle avec celui-ci, et la rétribution de l'électricité injectée pour l'installation solaire (10) respective est déterminée sur la base de l'énergie d'alimentation maximale possible ainsi calculée.

2. Procédé selon la revendication 1, selon lequel la réduction des puissances d'alimentation des installations solaires (10) s'effectue respectivement par le biais d'une commande de l'onduleur solaire (20) de l'installation solaire (10).

3. Procédé selon la revendication 2, selon lequel chaque installation solaire comprend un enregistreur de données (41), et les onduleurs solaires (20) sont commandés par l'enregistreur de données de l'installation solaire respective, afin d'obtenir la réduction de la puissance d'alimentation.

4. Procédé selon l'une des revendications précédentes, selon lequel, en cas d'interruption de la connexion de données (72) entre l'une des installations solaires (10) et le portail (82), cette installation solaire (10) stocke automatiquement les valeurs d'énergie mesurées, dans une mémoire de données (32) de cette installation solaire (10), et, lors du rétablissement de la connexion de données (72), les valeurs d'énergie mesurées sont transmises ultérieurement de façon automatique au portail (82), et les valeurs d'énergie transmises ultérieurement sont stockées par le portail (82).

5. Procédé selon l'une des revendications précédentes, selon lequel, côté courant continu (20a) de l'onduleur solaire (20) de chaque installation solaire (10), des mesures de courant (61-65) sont effectuées par groupes, et les valeurs de courant continu mesurées respectivement par groupes sont transmises régulièrement par les installations solaires (10), via la connexion de données (72) entre les installations solaires (10) et le portail (82), au dispositif de calcul (80) central du portail (82) et y sont stockées.

6. Procédé selon la revendication 5, selon lequel, en cas d'interruption de la connexion de données (72) entre l'une des installations solaires (10) et le portail (82), cette installation solaire (10) stocke automatiquement les valeurs de courant continu mesurées, dans la mémoire de données (32) de cette installation solaire (10), et, lors du rétablissement de la connexion de données (72), les valeurs de courant continu mesurées sont transmises ultérieurement de façon automatique au portail (82), et les valeurs de courant continu transmises ultérieurement sont stockées par le portail (82).

7. Procédé selon l'une des revendications précédentes, selon lequel les installations solaires (10) comprennent chacune un récepteur de télécommande centralisée (90), et la réduction fractionnaire des puissances d'alimentation des installations solaires (10) est déclenchée par un signal de télécommande centralisée (92) reçu par le récepteur de télécommande centralisée (90).

8. Procédé selon l'une des revendications précédentes, selon lequel les facteurs fractionnaires (B) des installations solaires (10), qui sont chacun pourvus d'un horodatage, sont transmis au portail (82) via la connexion de données (72) entre les installations solaires (10) et le portail (82), et sont stockés de façon décentralisée dans celui-ci.

**9.** Système comprenant : un fournisseur d'énergie; un réseau d'alimentation en courant (30) destiné à approvisionner en énergie électrique une pluralité d'utilisateurs; une multitude de centrales électriques alimentant le réseau d'alimentation en courant (30); une pluralité d'installations solaires photovoltaïques (10) injectant dans le réseau d'alimentation en courant (30); une pluralité d'utilisateurs qui sont approvisionnés en énergie électrique par le réseau d'alimentation en courant (30); et un portail (82) central,
où les installations solaires photovoltaïques (10) comportent respectivement :

- au moins un onduleur solaire (20) destiné à convertir la tension continue (18), produite par les modules solaires (16), en tension alternative (22) conforme au réseau,
- un dispositif de transmission de données (74, 76, 77) destiné à établir une connexion de données (72) avec le portail (82),
- un compteur d'énergie d'alimentation (50), côté courant alternatif (20b) de l'onduleur solaire (20), qui est conçu pour la mesure continue de l'énergie effectivement injectée dans le réseau public d'alimentation en courant (30) et pour la transmission régulière des valeurs d'énergie respectivement mesurées, via la connexion de données (72), à un dispositif de calcul (80) central du portail (82),
- une unité de commande (40) interne, destinée à commander la puissance de l'installation solaire (10) respective,

où le fournisseur d'énergie est relié via la connexion de données (92) aux installations solaires (10) et est conçu de manière telle que, suivant les besoins d'alimentation, il transmet un facteur fractionnaire (B) différent de zéro aux unités de commande (40) internes des installations solaires,
**caractérisé en ce que**
les unités de commande (40) internes sont conçues pour réduire la puissance d'alimentation de l'installation solaire (10) respective au facteur fractionnaire (B) différent de zéro, et
**en ce que** le fournisseur d'énergie ou le portail sont conçus de manière telle que
l'énergie d'alimentation maximale possible de chacune des installations solaires (10) est calculée à l'aide du facteur fractionnaire (B) et de la valeur d'énergie de l'installation solaire (10) respective, mesurée en continu et mise en corrélation temporelle avec celui-ci et transmise au dispositif de calcul (80) du portail (82), et la rétribution de l'électricité injectée pour l'installation solaire (10) respective est déterminée sur la base de l'énergie d'alimentation maximale possible ainsi calculée.

**10.** Installation solaire photovoltaïque (10) destinée à être raccordée à un réseau public d'alimentation en courant (30) d'un fournisseur d'énergie, comprenant :

un ou plusieurs groupes (11-15) comportant une pluralité de modules solaires (16),
au moins un onduleur solaire (20) à puissance commandée, destiné à la conversion de la tension continue (18), produite par les modules solaires (10), en tension alternative (22) conforme au réseau,
un dispositif de transmission de données (74, 76, 77) destiné à établir une connexion de données (72) avec un portail (82),
un compteur d'énergie d'alimentation (50), côté courant alternatif (20b) de l'onduleur solaire (20), qui est conçu pour la mesure continue de l'énergie effectivement injectée dans le réseau public d'alimentation en courant (30) et pour la transmission régulière des valeurs d'énergie respectivement mesurées, via la connexion de données (72), à un dispositif de calcul (80) central du portail (82),
une unité de commande (40) interne, conçue pour commander la puissance de l'onduleur solaire (20) jusqu'à un facteur fractionnaire (B) différent de zéro, reçu du fournisseur d'énergie,

**caractérisé en ce que** l'unité de commande (40) interne est conçue de manière à réduire du facteur fractionnaire (B) prédéterminé la puissance d'alimentation momentanée effective de l'installation solaire, de sorte que l'énergie d'alimentation maximale possible de l'installation solaire peut être calculée à l'aide du facteur fractionnaire variable dans le temps et des valeurs d'énergie mesurées en continu et mises en corrélation temporelle avec celui-ci et transmises.

Fig. 1